# EUROPEAN PATENT APPLICATION

(11) **EP 1 300 875 A1**
(43) Date of publication of application: **09.04.2003**
(21) Application number: 02707228.9
(22) Date of filing: 28.03.2002
(51) Int. Cl.: H01L 21/31, H05H 1/46, H01L 21/3065

(54) **PLASMA PROCESSING DEVICE**

(30) Priority: 28.03.2001 JP 2001094274
(71) Applicant: Ohmi, Tadahiro, Sendai-shi, Miyagi-ken 980-0813 (JP); TOKYO ELECTRON LIMITED, Minato-ku, Tokyo 107-8481 (JP)
(72) Inventor: OHMI, Tadahiro, Sendai-Shi, Miyagi 980-0813 (JP); HIRAYAMA,Masaki c/o N.I.C.H.C. Tohoku Univ.,, Sendai-Shi, Miyagi 980-8579 (JP); SUGAWA, Shigetoshi, Tohoku University, Sendai-Shi, Miyagi 980-8579 (JP); GOTO,T, c/o N.I.C.H.C. Tohoku University,, Sendai-Shi, Miyagi 980-8579 (JP); HONGOH, Toshiaki, Tokyo Electron Limited, Nirasaki-Shi, Yamanashi 407-0192 (JP)
(74) Representative: Liesegang, Eva
(86) International application number: JP0203107
(87) International publication number: WO02080248

(57) **Abstract**

In a microwave plasma processing apparatus that uses a radial line slot antenna, abnormal discharges are suppressed and the excitation efficiency of microwave plasma is improved simultaneously. In the joint between the radial line slot antenna and the coaxial waveguide, the point part of the power supplying line of the coaxial waveguide is separated from the slot plate constructing a radiation face.

## Description

### TECHNICAL FIELD

The present invention is generally related to a plasma processing apparatus, and more particularly, to a microwave plasma processing apparatus.

Plasma processing and plasma processing apparatuses are an indispensable technology for fabricating ultrafine semiconductor devices these days called deep submicron devices or deep subquarter micron devices characterized by a gate length of near 0.1µm or less, and for fabricating ultra high-resolution flat-panel display devices including liquid crystal display devices.

Conventionally, various plasma excitation methods have been used in plasma processing apparatuses used for fabrication of semiconductor devices and liquid crystal display devices. Particularly, a parallel-plate type high-frequency excitation plasma processing apparatus or an induction-coupled plasma processing apparatus are used commonly. However, such conventional plasma processing apparatuses have a drawback of non-uniform plasma formation in that the region of high electron density is limited, and it has been difficult to conduct a uniform process over the entire substrate surface with a high processing rate, and hence with high throughput. This problem becomes particularly acute when processing a large diameter substrate. Further, such a conventional plasma processing device has several inherent problems associated with its high electron temperature, in that the semiconductor devices formed on the substrate sustain damage and that significant metal contamination is caused as a result of sputtering of a chamber wall. Thus, there are increasing difficulties for such conventional plasma processing apparatuses to meet the stringent demand of further device miniaturization and further improvement of productivity in manufacturing semiconductor devices and liquid crystal display devices.

Meanwhile, there are proposals of a microwave plasma processing apparatus that uses high-density plasma excited by a microwave electric field, in place of a direct-current magnetic field. For example, there is a proposal of a plasma processing apparatus that causes excitation of plasma by radiating a microwave into a processing vessel from a planar antenna (radial line slot antenna) having a number of slots disposed so as to form a uniform microwave, such that the microwave electric field causes ionization of a gas in a vacuum vessel. (See for example Japanese Laid-Open Patent Application 9-63793). In the microwave plasma thus excited, it is possible to realize a high plasma density over a wide area right underneath the antenna, and it becomes possible to conduct uniform plasma processing in a short duration. The microwave plasma thus formed is characterized by low electron temperature, and damaging or metal contamination of the substrate is avoided. Further, it is possible to form uniform plasma over a large surface area, and it can be easily applied to the fabrication process of a semiconductor device using a large diameter semiconductor substrate and a large size liquid crystal display device.

### BACKGROUND ART

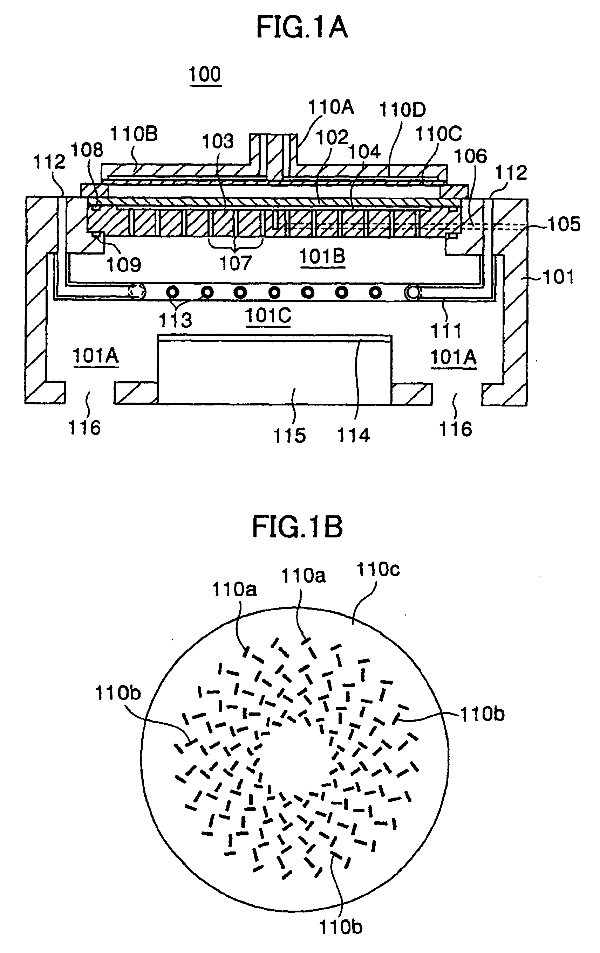

FIGS.1A and 1B show the construction of a conventional microwave plasma processing apparatus 100 having such a radial line slot antenna, wherein FIG.1A shows the microwave plasmas processing apparatus in a cross-sectional view while FIG.1B shows the construction of the radial line slot antenna.

Referring to FIG.1A, the microwave plasma processing apparatus 100 has a processing chamber 101 evacuated from plural evacuation ports 116, and there is formed a stage 115 for holding a substrate 114 to be processed. In order to realize uniform processing in the processing chamber 101, a ring-shaped space 101A is formed around the stage 115, and the plural evacuation ports 116 are formed in communication with the foregoing space 101A at a uniform interval, and hence in axial symmetry with regard to the substrate. Thereby, it becomes possible to evacuate the processing chamber 101 uniformly through the space 101A and the evacuation ports 116.

On the processing chamber 101, there is formed a shower plate 103 of plate-like form at the location corresponding to the substrate 114 on the stage 115 as a part of the outer wall of the processing chamber 101 via a seal ring 109, wherein the shower plate 103 is formed of a dielectric material of small loss and includes a large number of apertures 107. Further, a cover plate 102 also of a dielectric material of small loss is provided on the outer side of the shower plate 103 via another seal ring 108.

The shower plate 103 is formed with a passage 104 for a plasma gas on the top surface thereof, and each of the plural apertures 107 are formed in communication with the foregoing plasma gas passage 104. Further, there is formed a plasma gas supply passage 106 in the interior of the shower plate 103 in communication with a plasma gas supply port 105 provided on the outer wall of the processing vessel 101. Thus, the plasma gas of Ar, Kr or the like supplied to the foregoing plasma gas supply port 105 is supplied to the foregoing apertures 107 from the supply passage 106 via the passage 104 and is released into a space 101B right underneath the shower plate 103 in the processing vessel 101 from the apertures 107 with substantially uniform concentration.

On the processing vessel 101, there is provided a radial line slot antenna 110 having a radiation surface shown in FIG.1B on the outer side of the cover plate 102 with a separation of 4 - 5 mm from the cover plate 102. The radial line slot antenna 110 is connected to an external microwave source (not shown) via a coaxial waveguide 110A and causes excitation of the plasma gas released into the space 101B by the microwave from the microwave source. It should be noted that the gap between the cover plate 102 and the radiation surface of the radial line slot antenna 110 is filled with air.

The radial line slot antenna 110 is formed of a flat disk-like antenna body 110B connected to an outer waveguide of the coaxial waveguide 110A and a radiation plate 110C is provided on the mouth of the antenna body 110B, wherein the radiation plate 110C is formed with a number of slots 110a and slots 110b wherein slots 110b are formed in a direction crossing the slots 110a perpendicularly as represented in FIG.1B. Further, a retardation plate 110D of a dielectric film of uniform thickness is inserted between the antenna body 110B and the radiation plate 110C.

In the radial line slot antenna 110 of such a construction, the microwave supplied from the coaxial waveguide 110 spreads between the disk-like antenna body 110B and the radiation plate 110C as it is propagated in the outward radial directions, wherein there occurs a compression of wavelength as a result of the action of the retardation plate 110D. Thus, by forming the slots 110a and 110b in concentric relationship in correspondence to the wavelength of the radially propagating microwave so as to cross perpendicularly with each other, it becomes possible to emit a plane wave having a circular polarization state in a direction substantially perpendicular to the radiation plate 110C.

By using such a radial line slot antenna 110, uniform plasma is formed in the space 101B right underneath the shower plate 103. The high-density plasma thus formed is characterized by a low electron temperature and thus, no damage is caused to the substrate 114 and no metal contamination results due to sputtering of the vessel wall of the processing vessel 101.

In the plasma processing apparatus of FIG.1, it should further be noted that there is provided a conductive structure 111 in the processing vessel 101 between the shower plate 103 and the substrate 114, wherein the conductive structure is formed with a number of nozzles 113 supplied with a processing gas from an external processing gas source (not shown) via a processing gas passage 112 formed in the processing vessel 101, and each of the nozzles 113 releases the processing gas supplied thereto into a space 101C between the conductive structure 111 and the substrate 114. It should be noted that the conductive structure 111 is formed with openings between adjacent nozzles 113 with a size such that the plasma formed in the space 101B passes efficiently from the space 101B to the space 101C by way of diffusion.

Thus, in the case wherein a processing gas is released into the space 101C from the conductive structure 111 via the nozzles 113, the processing gas is excited by the high-density plasma formed in the space 101B and uniform plasma processing is conducted on the substrate 114 efficiently and at a high rate, without damaging the substrate or the devices on the substrate, and without contaminating the substrate. Further, it should be noted that the microwaves emitted from the radial line slot antenna 110 are blocked by the conductive structure 111 and there is no possibility of such microwaves causing damage to the substrate 114.

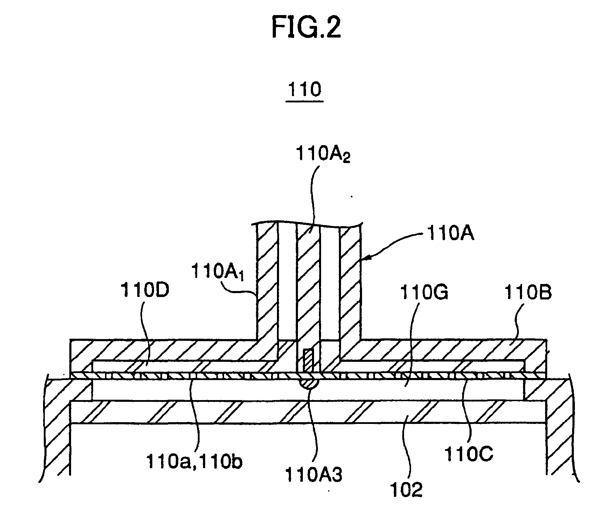

Fig. 2 is a partially expanded view of the radial line slot antenna 110 of the plasma processing apparatus 100 showed in Fig. 1.

In Fig. 2, the coaxial waveguide 110A has a center conductor 110A₂ in an external waveguide 110A₁ connected to the antenna body 110B. The center conductor 110A₂ is connected to the slot plate 110C via an opening formed in the retardation plate 110D.

Conventionally, the slot plate 110C is fixed to the center conductor 110A₂ by a screw 110A₃. The top of the screw 110A₃, however, protrudes from the slot plate 110C. In the case of the conventional plasma processing apparatus 100 showed in Fig. 1, a clearance 110G of 6 mm height is provided between the slot plate 110C and the cover plate 102 so as to store the top of the screw 110A₃.

However, the top of the screw 110A₃ protruding on the face of the slot plate 110C induces a concentration of the electric field, which easily causes abnormal discharge. Such abnormal discharge damages the antenna and shortens its life.

The construction showed in Figs. 1 and 2 causes a problem such that the heat transferred from the high density plasma formed in the processing chamber 101 easily accumulates in the cover plate 102 and the shower plate 103 because the clearance 110G is formed between the slot plate, that is, the radial line slot antenna 110, and the cover plate 102. When the heat accumulates, as described above, in the cover plate 102 and the shower plate 103 of the plasma processing apparatus 100 showed in Fig. 1, the temperature of the shower plate 103 increases, which results in the dissociation of certain kinds of plasma gases provided from the supply port 105. This problem is serious since the plasma processing apparatus 100 is usually operated with the processing chamber 101 heated up to about 150 degree C so as to avoid the formation of deposits on the inner face of the processing chamber 101.

Though it is possible to make the shower plate 103 or the cover plate 102 of thermally conductive materials such as AlN in order to avoid heat buildup in the shower plate 103 or the cover plate 102, the alternative material increases dielectric loss, which results in difficulties in forming microwave plasma.

### DISCLOSURE OF THE INVENTION

Accordingly, it is an object of the present invention to provide a novel and useful plasma processing apparatus wherein the foregoing problems are eliminated.

Another and more specific object of the present invention is to provide a plasma processing apparatus in which the abnormal discharge on the face of the radial line slot antenna is eliminated, and additionally, the efficiency of heat dissipation is improved.

Yet another object of the present invention is to improve the efficiency of plasma excitation by the microwave antenna of the plasma processing apparatus.

The present invention achieves one or more of the above objects by providing a plasma processing apparatus, comprising
a processing vessel defined by an outer wall and having a stage for holding a substrate to be processed,
an evacuation system coupled to said processing vessel,
a plasma gas supplying part for supplying plasma gas to said processing vessel,
a microwave antenna provided on said processing vessel in correspondence to said plasma gas supplying part, said microwave antenna being supplied with electric power through a coaxial waveguide, and
a microwave power source coupled to said microwave antenna electrically, said microwave antenna being defined by a first outer surface forming a microwave radiation surface and a second outer surface opposing said first outer surface,
wherein
an outer waveguide constructing said coaxial waveguide is coupled to said second outer surface, and
a center conductor constructing said coaxial waveguide, a point part of which is separated from said first outer surface, forms capacitive coupling with said first outer surface.

According to the present invention, the center conductor of the coaxial waveguide supplying microwave electric power to the radial line slot antenna is not coupled directly to the conductive slot plate forming the radiation surface of the radial line slot antenna, and consequently, the conductive slot plate does not need to be fixed to the center conductor by a screw. As a result, problems such as the concentration of electric field and associated abnormal discharge caused by the protrusion of the top of the screw are eliminated. The plasma processing can be performed stably without damaging the antenna.

According to the present invention, because the conductive slot plate does not need to be fixed to the center conductor by the screw, no room to store the protruding top of the screw is required between the conductive slot plate and the outer wall of the processing vessel. It is possible to place the conductive slot plate in intimate contact with the microwave transparent window formed on the outer wall of the processing vessel. As a result, the microwave transparent window can be cooled by cooling the antenna so that it is possible to make the microwave transparent window and/or the shower plate to supply plasma gas, of Al2O3 that has not been used conventionally because its dielectric loss is small but thermal conductivity is too low. Likewise, the retardation plate provided between the first surface and the second surface of the antenna can be made of Al2O3, SiO2, and SiN of low dielectric loss instead of conventionally used AlN of high dielectric loss. One can select the best material based on the frequency of the microwave to be used.

In the present invention, a shower plate made of a dielectric material of low dielectric loss, having a plasma gas passage and a plurality of apertures communicating to the plasma gas passage is used as the plasma gas supplying part to provide uniform plasma gas. However, the plasma gas can be provided through a tube provided on the outer wall of the processing vessel. In the latter case, the construction becomes simpler, and the cost incurred in manufacturing the plasma processing apparatus may be greatly reduced.

The impedance change between the center conductor and the slot plate is optimized by separating the point part of the center conductor from the slot plate by about 3.8 mm, which minimizes the reflection of microwaves due to capacitive coupling. The taper structure formed at the point part of the center conductor optimizes the impedance change between the center conductor and the slot plate.

Especially, according to the present invention, the microwave antenna can be provided so that the slot plate is exposed to the aperture formed on the outer wall of the processing vessel. In the present invention, since a uniform retardation plate is continuously formed on the back of the slot plate in the microwave antenna, the processing vessel is efficiently sealed by sealing only the peripheral part of the antenna with sealing material. In the case of the above construction, because the slot plate is exposed in the processing vessel, the microwave is not attenuated by a microwave transparent window, for example, and consequently, the microwave plasma is efficiently excited.

In the case of a conventional plasma processing apparatus, the point part of the center conductor pierces the retardation plate reaching the slot plate. It is necessary to provide a sealing member between the retardation plate and the center conductor if one desires the slot plate to be exposed in the processing vessel. The sealing member thus provided at this position, however, is degraded by strong heating. Embodying such a construction is difficult. The present invention solves these difficulties with simple constructions and provides a plasma processing apparatus of high efficiency.

### BRIEF DESCRIPTION OF THE DRAWINGS

FIGS. 1A and 1B are diagrams showing the construction of a conventional microwave plasma processing apparatus that uses a radial line slot antenna;
FIG.2 is a diagram showing a portion of the microwave plasma processing apparatus of FIG.1;
FIGS. 3A and 3B are diagrams showing the construction of a microwave plasma processing apparatus according to a first embodiment of the present invention;
FIG. 4 is a diagram showing the construction of a process gas supplying mechanism of the microwave plasma processing apparatus of FIG. 3;
FIG. 5 is a diagram showing the distribution of microwaves in the plasma processing apparatus showed in FIG. 3;
FIG. 6 is a diagram showing the construction of the microwave power source coupled to the microwave plasma processing apparatus of FIG.3A;
FIG.7 is a diagram showing the construction of a microwave plasma processing apparatus according to a second embodiment of the present invention;
FIG.8 is a diagram showing the construction of a microwave plasma processing apparatus according to a third embodiment of the present invention;
FIG.9 is a diagram showing the construction of a microwave plasma processing apparatus according to a fourth embodiment of the present invention; and
FIG.10 is a diagram showing the construction of a microwave plasma processing apparatus according to a fifth embodiment of the present invention.

### BEST MODE FOR IMPLEMENTING THE INVENTION

### [FIRST EMBODIMENT]

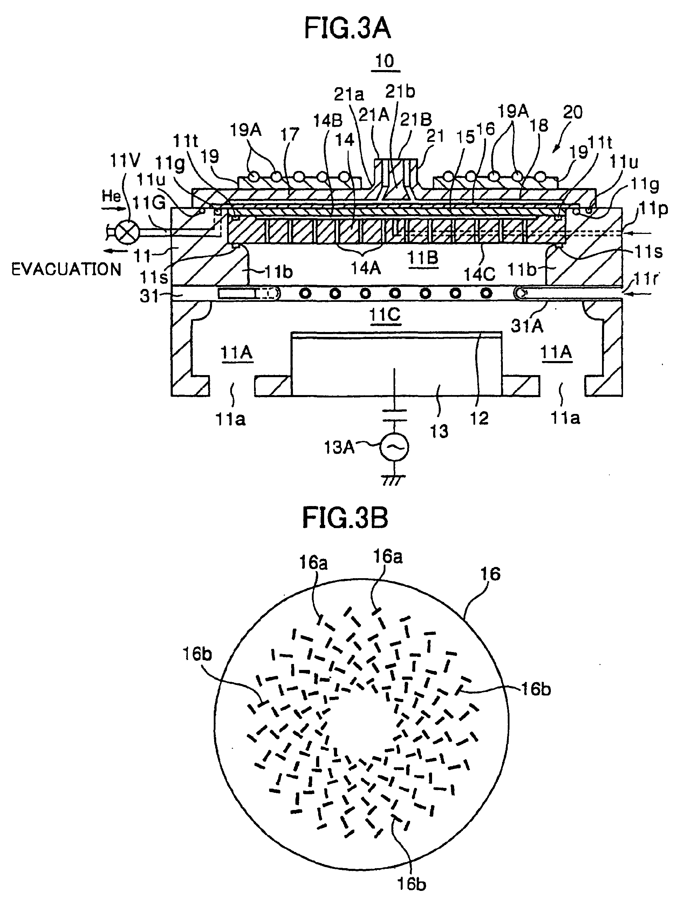

FIGS.3A and 3B are diagrams showing the construction of a microwave plasma processing apparatus 10 according to a first embodiment of the present invention.

Referring to FIG.3A, the microwave plasma processing apparatus 10 includes a processing vessel 11 and a stage 13 provided in the processing vessel 11 for holding a substrate 12 to be processed by an electrostatic chuck, wherein the stage 13 is preferably formed of AlN or Al₂O₃ by a hot isostatic pressing (HIP) process. In the processing vessel 11, there are formed two or three evacuation ports 11a in a space 11A surrounding the stage 13 with an equal distance, and hence with an axial symmetry with respect to the substrate 12 on the stage 13. The processing vessel 11 is evacuated to a low pressure via the evacuation port 11a by a gradational lead screw pump.

The processing vessel 11 is preferably formed of an austenite stainless steel containing Al, and there is formed a protective film of aluminum oxide on the inner wall surface by an oxidizing process. Further, there is formed a disk-shaped shower plate 14 of dense Al₂O₃, formed by a HIP process, in the part of the outer wall of the processing vessel 11 corresponding to the substrate 12 as a part of the outer wall, wherein the shower plate 14 includes a large number of nozzle apertures 14A. The Al₂O₃ shower plate 14 thus formed by a HIP process is formed by using an Y₂O₃ additive and has porosity of 0.03% or less. This means that the Al₂O₃ shower plate is substantially free from pores or pinholes and has a very large, while not so large as that of AlN, thermal conductivity for a ceramic of 30W/m · K.

The shower plate 14 is mounted on the processing vessel 11 via a seal ring 11s, and a cover plate 15 of dense Al₂O₃ formed also of an HIP process is provided on the shower plate 14 via a seal ring 11t. The shower plate 14 is formed with a depression 14B communicating with each of the nozzle apertures 14A and serving for the plasma gas passage, at the side thereof contacting with the cover plate 15, wherein the depression 14B also communicates with another plasma gas passage 14C formed in the interior of the shower plate 14 in communication with a plasma gas inlet 11p formed on the outer wall of the processing vessel 11.

The shower plate 14 is held by an extending part 11b formed on the inner wall of the processing vessel 11, wherein the extending part 11b is formed with a round surface at the part holding the shower plate 14 so as to suppress electric discharge.

Thus, the plasma gas such as Ar or Kr supplied to the plasma gas inlet 11p is supplied to a space 11B right underneath the shower plate 14 uniformly via the apertures 14A after being passed through the passages 14C and the depression 14B in the shower plate 14.

On the cover plate 15, there is provided a radial line slot antenna 20 formed of a disk-shaped slot plate 16 formed with a number of slots 16a and 16b shown in FIG.3B in intimate contact with the cover plate 15, a disk-shaped antenna body 17 holding the slot plate 16, and a retardation plate 18 of a dielectric material of low loss such as Al₂O₃, SiO₂ or Si₃N₄ sandwiched between the slot plate 16 and the antenna body 17. The radial line slot antenna 20 is mounted on the processing vessel 11 by way of a seal ring 11u, and a microwave of 2.45GHz or 8.3 GHz frequency is fed to the radial line slot antenna 20 from an external microwave source (not shown) via a coaxial waveguide 21. The microwave thus supplied is radiated into the interior of the processing vessel from the slots 16a and 16b on the slot plate 16 via the cover plate 15 and the shower plate 14. Thereby, the microwaves cause excitation of plasma in the plasma gas supplied from the apertures 14A in the space 11B right underneath the shower plate 14. It should be noted that the cover plate 15 and the shower plate 14 are formed of Al₂O₃ and function as an efficient microwave-transmitting window. In order to avoid plasma excitation in the plasma gas passages 14A - 14C, the plasma gas is held at the pressure of about 6666Pa - 13332Pa (about 50 - 100Torr) in the foregoing passages 14A - 14C.

In order to improve intimate contact between the radial line slot antenna 20 and the cover plate 15, the microwave plasma processing apparatus 10 of the present embodiment has a ring-shaped groove 11g on a part of the processing vessel 11 so as to engage with the slot plate 16. By evacuating the groove 11g via an evacuation port 11G communicating therewith, the pressure in the gap formed between the slot plate 16 and the cover plate 15 is reduced and the radial line slot antenna 20 is urged firmly upon the cover plate 15 by the atmospheric pressure. It should be noted that such a gap includes not only the slots 16a and 16b formed in the slot plate 16 but also a gap formed for various other reasons. It should be noted further that such a gap is sealed by the seal ring 11u provided between the radial line slot antenna 20 and the processing vessel 11.

By filling the gap between the slot plate 16 and the cover plate 15 with an inert gas of small molecular weight via the evacuation port 11G and the groove 11g, heat transfer from the cover plate 15 to the slot plate 16 is facilitated. Thereby, it is preferable to use He for such an inert gas in view of large thermal conductivity and large ionization energy. In the case wherein the gap is filled with He, it is preferable to set the pressure to about 0.8atm. In the construction of FIG.3, there is provided a valve 11V on the evacuation port 11G for the evacuation of the groove 15g and filling of the inert gas into the groove 15g.

It should be noted that an outer waveguide tube 21A of the coaxial waveguide 21A is connected to the disk-shaped antenna body 17 while the point part 21b of a center conductor 21B is connected to the slot plate 16 via an opening formed in the retardation plate 18. That is, the point part 21b is preferably formed at a distance of more than 1 mm, more preferably, 3.8 mm from the slot plate 16. Thus, the microwave fed to the coaxial waveguide 21A is propagated in the outer radial directions between the antenna body 17 and the slot plate 16 and is emitted from the slots 16a and 16b. If the distance between the retardation plate 18 and the slot plate 16, that is, the thickness of the retardation plate 18, is less than 1 mm, the risk of breakdown increases (becomes not negligible). In the case of 2.45 GHz microwave, the maximum efficiency of supplying power is achieved with the distance between the point part 21b and the slot plate 16 being about 3.8 mm.

A taper unit 21a is formed correspondingly to the taper unit 21b of the center conductor 21B at the point part of the outer waveguide tube 21A, that is, the joint between the outer waveguide tube 21A and the antenna body 17.

FIG.3B shows the slots 16a and 16b formed on the slot plate 16.

Referring to FIG.3B, the slots 16a are arranged in a concentric manner such that there is provided a slot 16b for each slot 16a such that the slot 16b crosses the slot 16a perpendicularly and such that the slot 16b is aligned concentrically with the slot 16a. The slots 16a and 16b are formed with an interval corresponding to the wavelength of the microwave compressed by the radiation plate 16 in the radial direction of the slot plate 16, and as a result, the microwave is radiated from the slot plate 16 in the form of a near plane wave. Because the slots 16a and the slots 16b are formed in a mutually perpendicular relationship, the microwave thus radiated forms a circularly polarized wave including two perpendicular polarization components.

In the plasma processing apparatus 10 of FIG.3A, there is provided a cooling block 19 formed with a cooling water passage 19A on the antenna body 17, and the heat accumulated in the shower plate 14 is absorbed via the radial line slot antenna 20 by cooling the cooling block 19 with cooling water in the cooling water passage 19A. The cooling water passage 19A is formed on the cooling block 19 in a spiral form, and cooling water having a controlled oxidation-reduction potential is supplied thereto, wherein the control of the oxidation reduction potential is achieved by eliminating oxygen dissolved in the cooling water by way of bubbling of an H₂ gas.

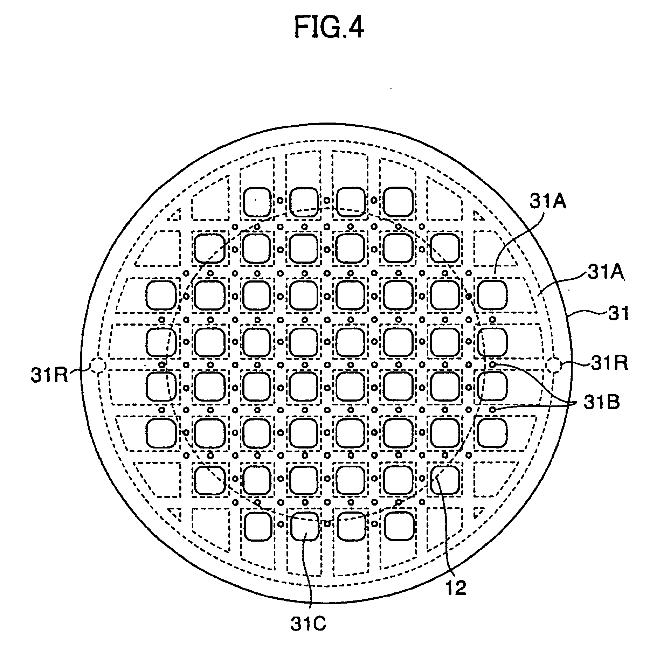

In the microwave plasma processing apparatus 10 of FIG.3A, there is further provided a process gas supply structure 31 in the processing vessel 11 between the shower plate 14 and the substrate 12 on the stage 13, wherein the process gas supply structure 31 has gas passages 31A arranged in a lattice shape and releases a process gas supplied from a process gas inlet port 11r provided on the outer wall of the processing vessel 11 through a large number of process gas nozzle apertures 31B (see FIG.4). Thereby, desired uniform substrate processing is achieved in a space 11C between the process gas supply structure 31 and the substrate 12. Such substrate processing includes plasma oxidation processing, plasma nitridation processing, plasma oxynitridation processing, and plasma CVD processing. Further, it is possible to conduct a reactive ion etching of the substrate 12 by supplying a readily decomposing fluorocarbon gas such as C₄F₈, C₅F₈ or C₄F₆ or an etching gas containing F or Cl from the process gas supply structure to the space 11C and further by applying a high-frequency voltage to the stage 13 from a high-frequency power source 13A.

In the microwave plasma processing apparatus 10 of the present embodiment, it is possible to avoid deposition of reaction byproducts on the inner wall of the processing vessel by heating the outer wall of the processing vessel 11 to a temperature of about 150°C. Thereby, the microwave plasma processing apparatus 10 can be operated constantly and with reliability, by merely conducing a dry cleaning process once a day or so.

In the case of the plasma processing apparatus 10 of Fig. 3A, the taper unit 21b of the center conductor 21B is formed at the joint/power supplying unit that connects the center conductor 21B to the taper unit 21b, and the corresponding taper unit 21a in the outer waveguide tube 21A. Thus, the rapid change in impedance caused by the joint/power supply unit is smoothed, which results in a reflective wave caused by the rapid change in impedance being greatly reduced.

FIG. 4 is a bottom view showing the construction of the process gas supply structure 31 of FIG.3A.

Referring to FIG. 4, the process gas supply structure 31 is formed by a conductive body such as an Al alloy containing Mg or a stainless steel added with Al and the lattice shaped gas passage 31A is connected to the process gas inlet port 11r at a process gas supply port 31R and releases the process gas uniformly into the foregoing space 11C from the process gas nozzle apertures 31B formed at the bottom surface. Further, there are formed openings 31C in the process gas supply structure 31 between the adjacent process gas passages 31A for passing the plasma or the process gas contained in the plasma therethrough. In the case wherein the process gas supply structure 31 is formed of an Al alloy containing Mg, it is preferable to form a fluoride film on the surface thereof. In the case wherein the process gas supplying structure 31 is formed of a stainless steel added with Al, it is preferable to form a passivation film of aluminum oxide on the surface thereof. In the plasma processing apparatus 10 of the present invention, the energy of incident plasma is low because of the low electron temperature of the excited plasma, and the problem of metal contamination of the substrate 12 by the sputtering of the process gas supply structure 31 is avoided. Further, it is possible to form the process gas supply structure 31 by a ceramic such as alumina.

The lattice shaped process gas passages 31A and the process gas nozzle apertures 31B are formed so as to encompass an area slightly larger than the substrate 12 represented in FIG.4 by a broken line. By providing the process gas supply structure 31 between the shower plate 14 and the substrate 12, the process gas is excited by the plasma and uniform processing becomes possible by using such plasma excited process gas.

In the case of forming the process gas supply structure 31 by a conductor such as a metal, the process gas supply structure 31 can form a shunting plane of the microwaves by setting the interval between the lattice shaped process gas passages 31A shorter than the microwave wavelength. In such a case, the microwave excitation of plasma takes place only in the space 11B, and there occurs excitation of the process gas in the space 11C including the surface of the substrate 12 by the plasma that has caused diffusion from the excitation space 11B. Further, such a construction can prevent the substrate from being exposed directly to the microwave at the time of ignition of the plasma, and thus, damaging of the substrate by the microwave is avoided.

In the microwave plasma processing apparatus 10 of the present embodiment, the supply of the process gas is controlled uniformly by the process gas supply structure 31, and the problem of excessive dissociation of the process gas on the surface of the substrate 12 is eliminated. Thus, it becomes possible to conduct the desired substrate processing even in the case wherein there is formed a structure of large aspect ratio on the surface of the substrate 12 up to the very bottom of the high aspect ratio structure. This means that the microwave plasma processing apparatus 10 is effective for fabricating various semiconductor devices of different generations characterized by different design rules.

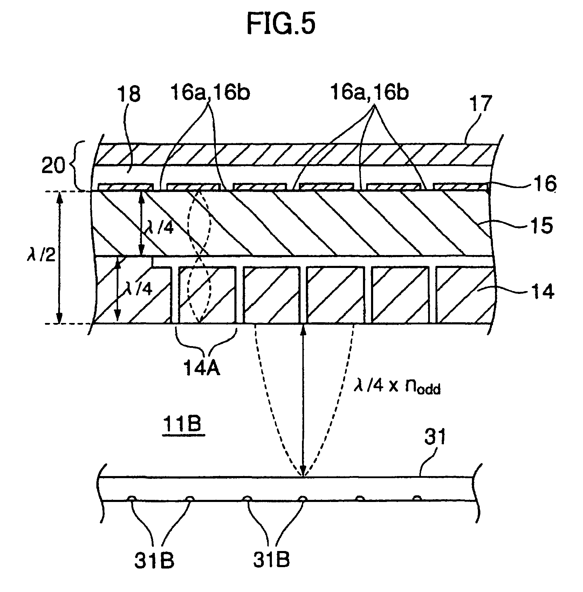

FIG.5 is a diagram showing a part of the plasma processing apparatus 10 of FIG.3A including the shower plate 14, the cover plate 15 and the radial line slot antenna 20.

Referring to FIG.5, it is preferable to set the distance between the bottom surface of the shower plate 14 and the process gas supplying structure 31 to be equal to an integer multiple of the quarter wavelength of the microwave for efficient excitation of plasma in the region right underneath the shower plate 14. By doing so, the anti-node of the standing wave formed between the process gas supply structure 31 functioning as the microwave shunting plane and the bottom surface of the shower plate 14 is located right underneath the shower plate 14.

In order to avoid electric discharge at the slots 16a and 16b, it is preferable that the node of the microwave emitted from the radial line slot antenna 20 be located coincident to the slots 16a and 16b. Further, it is preferable that the node be located also coincident to the bottom surface of the shower plate 14 for avoiding the electric discharge in the shower nozzle apertures 14A. Because of this reason, it is preferable to set the total thickness of the shower plate 14 and the cover plate 15 to be equal to one-half the wavelength of the microwave.

By setting the thickness of each the shower plate 14 and the cover plate 15 to be equal to a quarter wavelength of the microwave, in particular, the node of the microwave is located in the vicinity of the interface between the shower plate 14 and the cover plate 15, and the electric discharge in the plasma gas passage 14B, which is formed along this interface, is effectively suppressed.

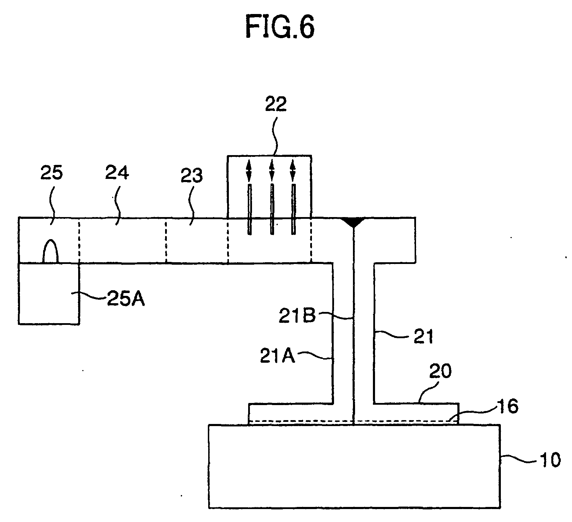

FIG.6 shows the schematic construction of the microwave source connected to the coaxial waveguide 21 of FIG. 2A.

Referring to FIG.6, the coaxial waveguide is connected to an edge of the waveguide extending from an oscillation part 25 including therein a magnetron 25A oscillating at the frequency of 2.45GHz or 8.3GHz via an isolator 24, a power monitor 23 and a tuner 22 in this order. Thus, the microwave formed by the oscillator 25 is supplied to the radial line slot antenna 20, and the microwave reflected back from the high-density plasma formed in the plasma processing apparatus 10 is returned again to the radial line slot antenna 20 after conducting an impedance adjustment by the tuner 22. Further, the isolator 24 is an element having directivity and functions so as to protect the magnetron 25A in the oscillation part 25 from the reflection wave.

In the microwave plasma processing apparatus 10 of the present embodiment, the rapid change in impedance caused by the joint is reduced by forming the taper units 21At and 21Bt at the joint, or the power supplying unit, between the coaxial waveguide 21 and the radial line slot antenna 20. As a result, the reflection of microwaves caused by the rapid change in impedance is suppressed, which makes the supplying of microwaves from the coaxial waveguide 21 to the antenna 20 stable.

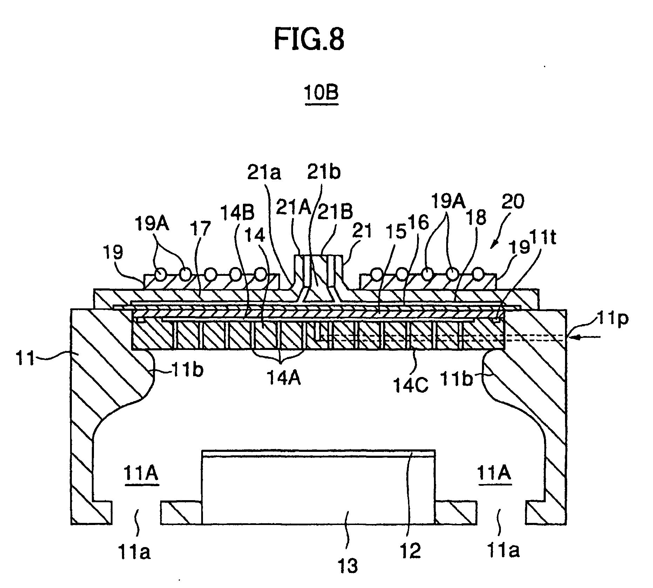

In addition, in the microwave plasma processing apparatus 10 according to the present embodiment, as showed in a variation showed in Fig. 8, it is possible to replace the taper faces 21At and 21Bt with round faces 21Ar and 21Br, respectively. The change in impedance caused by the joint is further reduced by forming the round faces, which results in further efficient suppressing of the reflective wave.

In the microwave plasma processing apparatus 10 of the present embodiment, the distance between the shower plate 14 exposed to the heat caused by the plasma and the cooing part is reduced substantially as compared with the conventional microwave plasma processing apparatus of FIGS.1A and 1B, and as a result, it becomes possible to use a material such as Al₂O₃ having a small dielectric loss and also a small thermal conductivity for the microwave transmission window in place of AlN, which is characterized by large dielectric loss. Thereby, the efficiency of plasma processing and hence the processing rate are improved while simultaneously suppressing the temperature rise of the shower plate.

In the microwave plasma processing apparatus 10 of the present embodiment, it should be further noted that the gas including the reaction byproduct formed in the space 11C as a result of the substrate processing forms a stable gas flow to the space 11A at the outer surrounding area because of the reduced distance between the shower plate 14 and the substrate 12 facing the shower plate 14, and the byproduct is removed from the space 11C quickly. By maintaining the temperature of the outer wall of the processing vessel 11 to be about 150°C, it becomes possible to eliminate the deposition of the reaction byproduct on the inner wall of the processing vessel 11 substantially completely, and the processing apparatus 10 becomes ready for the next process quickly.

By the way, in the above description of the present embodiment, specific dimensions are mentioned, but the present invention is not limited to these figures.

### [SECOND EMBODIMENT]

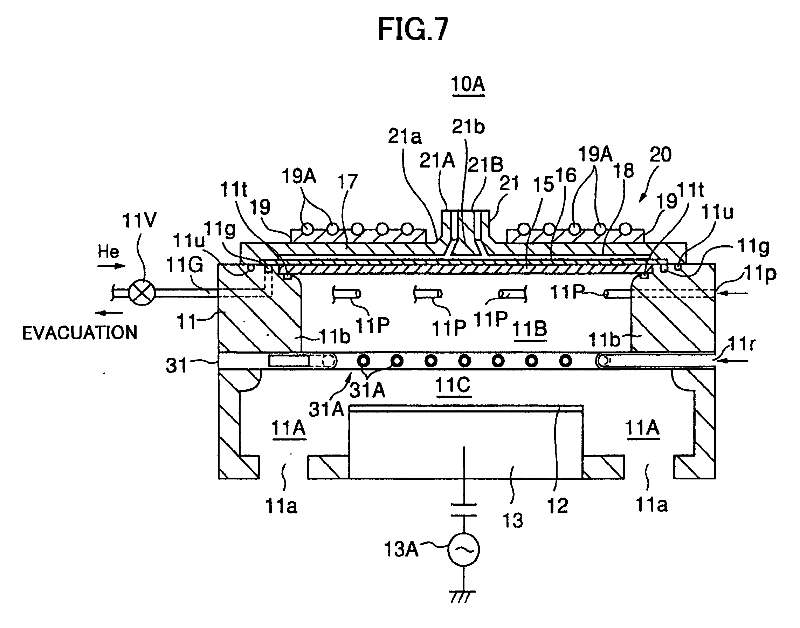

Fig. 7 is a diagram showing the construction of a plasma processing apparatus 10A according to a second embodiment of the present invention. In Fig. 7, the parts described earlier are referred to by the same reference numerals, and their description is omitted.

Referring to Fig. 7, the plasma processing apparatus 10A has a construction similar to the plasma processing apparatus 10 showed in Figs. 3A and 3B. They are different, however, in that the shower plate 14 is removed, and the gas inlets 11P protrude from the gas inlet ports 11p in the space 11B of the processing vessel.

This construction can form high density plasma in the space 11B by exciting the plasma gas supplied through the gas inlets 11P by the microwave supplied by the radial line slot antenna 20.

The high density plasma thus formed is less uniform than the high density plasma obtained using the shower plate 14, but the construction of the plasma processing apparatus 10A is much simpler than that of the foregoing plasma processing apparatus 10. In this embodiment, the heat flow entering to the cover plate 15 is absorbed by the cooling unit 17 via the radial line slot antenna 20.

In the plasma processing apparatus 10A of Fig. 7, it is preferable that plural inlets 11P be provided at symmetrical positions around the substrate in order to form plasma as uniform as possible.

In the present embodiment, the protrusion of the top of screw from the face of the slot plate 16 can be avoided by forming the point part 21b of the center conductor 21B of the coaxial waveguide at a distance from the slot plate 16 to form capacitive coupling between the two. It is possible to couple the antenna 20 so that the slot plate 16 coheres with the cover plate 15.

### [THIRD EMBODIMENT]

Fig. 8 is a diagram showing the construction of a microwave plasma processing apparatus 10B according to a third embodiment of the present invention. In Fig. 8, parts that have been previously described are referred to by the same numerals, and their description will be omitted.

Referring to Fig. 8, the construction of the microwave plasma processing apparatus 10B is similar to that of the microwave plasma apparatus processing 10 described previously. The microwave plasma processing apparatus 10B is different, however, in that the process gas supply structure 31 is removed. Additionally, the lower face of the extending part 11b of the processing vessel 11 is round so as to avoid abnormal discharge.

The construction of the plasma processing apparatus 10B prevents problems of the plasma forming just under the shower plate 14 reflecting the microwaves so that the microwaves reach the surface of the substrate 12, and the plasma being excited in the region near the surface. It is possible to prevent the microwave from reaching, and damaging, the substrate at the ignition of the plasma by setting the pressure in the processing vessel temporarily at a high level, 133 Pa (about 1 Torr), for example, to make sure that the plasma is ignited. The pressure in the processing vessel is soon adjusted to the process pressure, 13.3 Pa (about 0.1 Torr), for example, after the ignition of the plasma.

In the plasma processing apparatus 10B, because the process gas supply structure 30 is removed, the process gas needs to be supplied from the plasma gas supply port 11p with the plasma gas. Accordingly, the plasma processing apparatus 10B can perform oxidation processing, nitridation processing, oxynitridation processing, and so forth on the surface of the substrate 12.

In the present embodiment, the protrusion of the top of screw from the face of the slot plate 16 can be avoided by forming the point part 21b of the center conductor 21B of the coaxial waveguide at a distance from the slot plate 16 to form capacitive coupling between the two. It is possible to couple the antenna 20 so that the slot plate 16 coheres with the cover plate 15.

### [FOURTH EMBODIMENT]

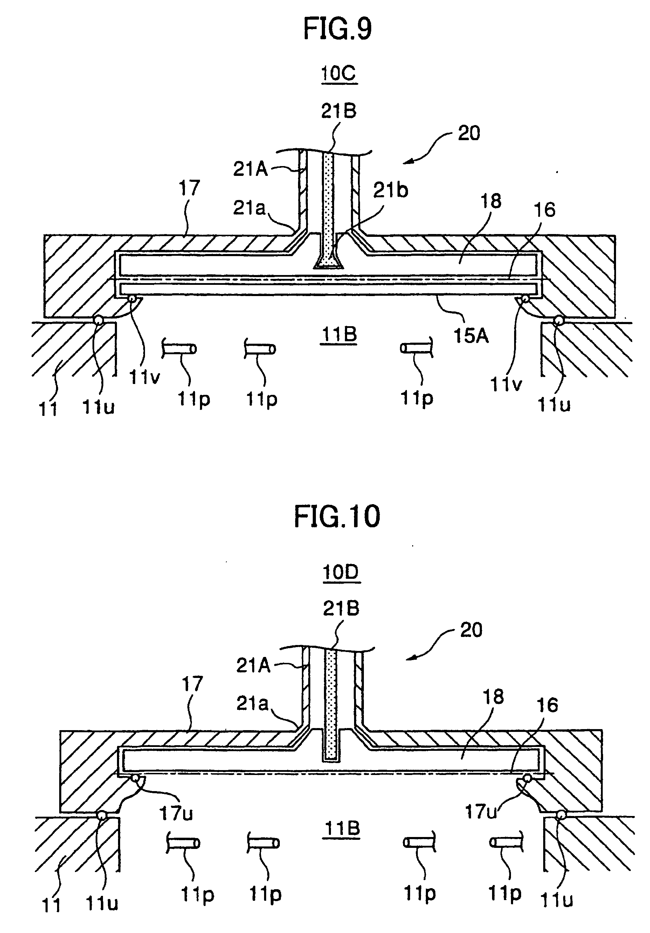

Fig. 9 is a diagram showing a plasma processing apparatus 10C according to a fourth embodiment of the present invention. In Fig. 9, parts that have been previously described are referred to by the same numerals, and their description will be omitted.

Referring to Fig. 9, the cover plate 15 is formed as the part of the microwave antenna 20, instead of the part of the processing vessel 11.

Specifically, the antenna body 17 is assembled to the processing vessel 11 via the seal ring 11u. In the present embodiment, the cover plate 15 that is formed as the part of the outer wall of the processing vessel 11 is removed, and a dielectric plate 15A covering the slot plate 16 is provided as a monolith on the antenna 17 instead. The dielectric plate 15A coheres with the slot plate 16, whereas the slot plate 16 is supported by the antenna body 17 via the retardation plate 18.

Because of this construction, when the processing vessel 11 is evacuated, the antenna 20 is put under great atmospheric pressure. In the present embodiment, however, the antenna body 17 can absorb the tension caused by the atmospheric pressure. The thickness of the dielectric plate 15A is consequently reduced. As a result, the loss of microwaves caused by the dielectric plate 15A is reduced, and the excitation efficiency of the high density plasma in the space 11B of the processing vessel 11 is improved.

In the plasma processing apparatus 10C showed in Fig. 9, similarly to the construction of Fig. 8, the shower plate 14 is not provided, and the plasma gas is supplied through the inlets 11P. It is possible to provide the plasma processing apparatus 10C with the shower plate 14.

### [FIFTH EMBODIMENT]

Fig. 10 is a diagram showing the construction of a plasma processing apparatus 10D according a fifth embodiment of the present invention. In Fig. 10, the parts described previously are referred to by the same reference numerals, and their description is omitted.

Referring to Fig. 10, the dielectric plate 15A provided in the construction of the embodiment of Fig. 9 is omitted, and the slot plate 16 is exposed in the processing vessel 11.

In this construction, besides the seal ring 11u that seals the antenna body 17 to the outer wall of the processing vessel 11, there is provided another seal ring 17u provided between the slot plate 16 and the antenna body 17 so as to seal the interior of the antenna and the interior of the coaxial waveguide 21 to the space 11B in the processing vessel 11.

According to the construction, the microwave is provided directly from the slot plate 16 to the inner space 11B of the processing vessel 11, not through the dielectric plate 15A or the cover plate 15. It is possible to efficiently excite the microwave plasma in the inner space 11B.

The seal ring 17u does not suffer much damage since it is formed in the peripheral portion of the antenna body 17. The plasma processing apparatus 10D can perform stable plasma processing by cooling the antenna body 17 as in the embodiment of Figs. 3A and 3B.

In the construction of Fig. 10, when the processing vessel 11 is evacuated, the antenna 20 is put under great atmospheric pressure. In the present embodiment, however, the antenna body 17 can absorb the tension caused by the atmospheric pressure without mechanically damaging the retardation plate 18.

The preferred embodiments of the present invention are described above. The present invention is not limited to these embodiments, but various variations and modifications may be made without departing from the scope of the present invention.

### INDUSTRIAL APPLICABILITY

According to the present invention, the protrusion of the top of screw from the face of the slot plate can be avoided by providing the center conductor of the coaxial waveguide that supplies microwaves to the radial line slot antenna so that the point part of the center conductor is separated from the slot plate constructing the radial line slot antenna. The slot plate can cohere with a corresponding microwave transparent window. Thanks to the construction, abnormal discharge can be avoided, and the microwave transparent window can be efficiently cooled via the radial line slot antenna.

Additionally, the radial line slot antenna and the dielectric plate constructing the microwave transparent window can be monolithic by the present invention, and consequently, the excitation efficiency of the microwave plasma is improved.

Further, the radial line slot antenna is directly attachable to the processing vessel. Accordingly, the microwave is supplied directly to the processing vessel, not through the microwave transparent window, and the excitation efficiency of the microwave plasma is further improved.

## Claims

1. A plasma processing apparatus, comprising:
a processing vessel defined by an outer wall and having a stage for holding a substrate to be processed;
an evacuation system coupled to said processing vessel;
a plasma gas supplying part for supplying plasma gas to said processing vessel;
a microwave antenna provided on said processing vessel in correspondence to said plasma gas supplying part, said microwave antenna being supplied with electric power through a coaxial waveguide; and
a microwave power source coupled to said microwave antenna electrically, said microwave antenna being defined by a first outer surface forming a microwave radiation surface and a second outer surface opposing said first outer surface;
wherein
an outer waveguide constructing said coaxial waveguide is coupled to said second outer surface; and
a center conductor constructing said coaxial waveguide, a point part of which is separated from said first outer surface, forms capacitive coupling with said first outer surface.

2. The microwave plasma processing apparatus as claimed in claim 1, wherein, in said micro wave antenna,
a dielectric film is provided between said first outer surface and said second outer surface; and
said point part of said center conductor forms capacitive coupling with said first outer surface via said dielectric film.

3. The microwave plasma processing apparatus as claimed in claim 1, wherein said point part is separated from said first outer surface by about 3.8 mm.

4. The microwave plasma processing apparatus as claimed in claim 1, wherein said dielectric film is selected from SiO₂, Al₂O₃, and Si₃N₄.

5. The microwave plasma processing apparatus as claimed in claim 1, wherein
said processing vessel is provided, on said outer wall, with a microwave transparent window opposing said substrate on said stage; and
said microwave antenna is coupled to said microwave transparent window.

6. The microwave plasma processing apparatus as claimed in claim 5, wherein said microwave antenna is provided so that said first outer surface is in intimate contact with said microwave transparent window.

7. The microwave plasma processing apparatus as claimed in claim 1, wherein
an opening is formed on said outer wall of said processing vessel in correspondence with said substrate on said stage; and
said microwave antenna is provided so that said first outer surface opposes said substrate through said opening.

8. The microwave plasma processing apparatus as claimed in claim 7, wherein said first outer surface is made of aluminum or silicon.

9. The microwave plasma processing apparatus as claimed in claim 1, said point part of said center conductor forms a tapered part in which the diameter increases toward said first outer surface.

10. The microwave plasma processing apparatus as claimed in claim 1, wherein said plasma gas supplying part is provided opposing to said substrate and further comprises a dielectric plate on which a plasma gas passage that can communicate to said plasma gas supplying part and a plurality of aperture forming parts communicating thereto are formed.

11. The microwave plasma processing apparatus as claimed in claim 1, wherein said plasma gas supplying part is constructed by a plurality of tubes formed in said outer wall of said processing vessel that can communicate with a plasma gas source.

12. The microwave plasma processing apparatus as claimed in claim 1, further comprising:
a processing gas supplying part provided between said plasma gas supplying part and said substrate.

13. The microwave plasma processing apparatus as claimed in claim 12, wherein said processing gas supplying part is provided with a processing gas passage that can communicate with a processing gas source, a first aperture through which plasma flows, and a plurality of second apertures communicating with said processing gas passage.

14. The microwave plasma processing apparatus as claimed in claim 12, further comprising a high frequency power supply coupled to said stage.
